# EUROPEAN PATENT APPLICATION

(11) **EP 2 224 497 A1**
(43) Date of publication of application: **01.09.2010**
(21) Application number: 09153996.5
(22) Date of filing: 27.02.2009
(51) Int. Cl.: H01L 31/09, H01L 31/0352, H01L 31/113

(54) **Photodetector relying on phonon detection**

(71) Applicant: Hitachi Ltd., Chiyoda-ku Tokyo (JP)
(72) Inventor: Xu, Xiulai, Cambridge, Cambridgeshire CB3 0HE (GB); Williams, David, Cambridge, Cambridgeshire CB3 0HE (GB)
(74) Representative: Piotrowicz, Pawel Jan Andrzej

(57) **Abstract**

A photodetector comprises a photoabsorptive region (2) to absorb photons (9) and produce phonons (10) in response thereto. The phonons propagate anisotropically having at least one preferred direction of propagation and at least one conductive channel (16) configured to receive phonons propagating along a preferred direction of propagation.

## Description

The present invention relates to a photodetector.

High-sensitivity photodetectors are needed in a wide variety of applications including quantum information processing and bioimaging. For example, in quantum information processing applications, such as quantum communication and linear optical quantum computation, detectors need to resolve the number of incident photons. The number can be small, for example, just one or two photons.

Several types of photon-number-resolving detectors have been proposed.

"Noise-free high-efficiency photon-number-resolving detectors", D. Rosenberg, et al., Physical Review A, volume 71, page 061803 (2005) describes a superconducting transition-edge sensor comprising an absorber and a thermometer, formed in a thin film of tungsten, and a weak link to a thermal heat sink, cooled to a temperature below its superconducting transition temperature, namely about 110 mK. Absorption of a photon causes a small change in temperature of the absorber which in turn results in a measurable change in resistance. Although the sensor is highly sensitive (88% for light at 1550 nm), it operates at very low temperatures, i.e. of the order of tens and hundreds of milliKelvin, which can make it difficult to use and expensive to operate.

A detector which operates in a similar way is described in "Superconducting nanowire photon-number-resolving detector at telecommunication wavelengths" by Aleksander Divochiy et al., Nature Photonics volume 2, page 302 (2008). In this case, however, the detector comprises an array of superconducting nanowires and an external load arranged in parallel. When a photon is absorbed by a superconducting nanowire, the heat generated increases the resistance of the superconducting nanowire and causes current redistribution between the other nanowires and the change is detected across the load.

"An avalanche-photodiode-based photon-number-resolving detector", B. E. Kardynal, Z. L. Yuan and A. J. Shields, Nature Photonics, volume 2, page 425 (2008) describes an avalanche photodiode which can resolve photon number using a self-differencing circuit. However, the detector has a relatively low sensitivity.

EP 1 077 492 A describes a detector comprising a photoabsorptive region which absorbs incident photons to produce corresponding electron-hole pairs. An electrode is used to apply a bias to separate the electrons and holes. The electrons and holes are detected using a pair of single-electron transistors. Basing detection upon charge measurement can reduce efficiency because photo-generated charges carriers may recombine before being detected. Moreover, use of single-electron transistors can limit output signal size and can place additional constraints on operating temperature.

The present invention seeks to provide an improved photodetector.

According to a first aspect of the present invention there is provided a photodetector comprising a substrate having a first side and a second, opposite side, a photoabsorptive region to absorb photons and produce phonons in response thereto, wherein phonons propagate anisotropically having at least one preferred direction of propagation and at least one conductive channel configured to receive phonons propagating along a preferred direction of propagation wherein the photoabsorptive region and the at least one conductive channel are provided on the first side of the substrate.

Thus, phonons can be used to modulate charge carrier transport in the or each conductive channel and can be more efficient than relying on charge carrier detection. Moreover, single-electron transistors need not be used, which can allow the device to operate at higher temperatures.

There may be two, three, four or more conductive channels.

The photoabsorptive region may be planar and the or each conductive channel may lie in a plane which is substantially coplanar with the photoabsorptive region. The photoabsorptive region may include a conductive sheet and the or each conductive channel may include a respective conductive sheet. The conductive sheets may each comprise a respective portion of a δ-doped layer in a semiconductor layer structure or a respective portion of a two-dimensional electron or hole gas.

The photoabsorptive region and the at least one conductive channel may be disposed on a supporting structure provided on the first side of the substrate.

The or each conductive channel may be configured to lie within about 5 µm of the photoabsorptive region, preferably within about 2 µm, more preferably within about 1 µm, even more preferably within about 500 nm or still more preferably within about 200 nm.

The photoabsorptive region may be polygonal having vertices and each conductive channel may be configured to run adjacent to a respective vertex. The photoabsorptive region may be rhomboidal having four vertices and each conductive channel may be configured to run adjacent to a vertex. The photoabsorptive region may have a face having an area between about 100 µm² and about 10000 µm².

Each conductive channel may be provided with a respective gate so as to form at least one field-effect transistor.

The photoabsorptive region may be configured to absorb a photon and generate an electron-hole pair in response thereto and at least one phonon may be generated in response to the electron and hole recombining.

According to a second aspect of the present invention there is provided apparatus comprising the photodetector and a refrigerator in thermal contact with the photodetector configured to cool the photodetector to a temperature of between about 1 K and about 50 K. The refrigerator may be a cold finger cryostat.

According to a third aspect of the present invention there is provided a method of fabricating a photodetector, the method comprising providing a substrate having a first side and a second, opposite side, providing, on the first side of the substrate, a photoabsorptive region to absorb photons and produce phonons in response thereto, wherein phonons propagate anisotropically having at least one preferred direction of propagation and providing, on the first side of the substrate, at least one conductive channel configured to receive phonons propagating along a preferred direction of propagation.

Providing the photoabsorptive region and providing at least one conductive channel may comprise providing a layer structure including a conductive sheet and etching regions of the layer structure so as to leave a photoabsorptive region including a region of the conductive sheet and at least one conductive channel including respective regions of the conductive sheet.

According to a fourth aspect of the present invention there is provided a method of operating a photodetector which comprises a photoabsorptive region to absorb photons and produce phonons in response thereto, wherein phonons propagate anisotropically having at least one preferred direction of propagation and at least one conductive channel configured to receive phonons propagating along a preferred direction of propagation, the method comprising cooling the photodetector to a temperature about 1 K and about 50 K, applying a bias across the conductive channel and measuring current through the conductive channel.

Embodiments of the present invention will now be described, by way of example, with reference to the accompanying drawings, in which:
Figure 1 is a schematic plan view of a photodetector in accordance with the present invention;
Figure 1a is a more detailed plan view of a photoabsorptive region of the photodetector shown in Figure 1 and which illustrates schematically phonon focussing;
Figure 2 is a schematic sectional view of the photodetector shown in Figure 1 taken along the line A-A';
Figure 3 illustrates plots of current against gate voltage for a field-effect transistor of the photodetector shown in Figure 1 at 10 K and in the dark for different applied source-drain voltages;
Figure 4 is a schematic block diagram of a system used to illuminate, control and measure the photodetector shown in Figure 1;
Figure 5 illustrate time-dependent plots of current for two field-effect transistors of the photodetector shown in Figure 1 with light pulse modulation frequency of 0.1 Hz and a duty cycle of 20%;
Figure 6 illustrate time-dependent plots of current for two field-effect transistors of the photodetector shown in Figure 1 with light pulse modulation frequency of 1 Hz and a duty cycle of 20%;
Figure 7 illustrate probability histogram plots for the field-effect transistors of the photodetector shown in Figure 1 for different average photon numbers;
Figure 8 is a process flow diagram of a method of fabricating the photodetector shown in Figure 1;
Figures 9a to 9e illustrate the photodetector shown in Figure 1 at different stages during fabrication;
Figure 10 is a schematic plan view of another photodetector in accordance with the present invention having additional field-effect transistors;
Figure 11 is a schematic sectional view of a photodetector having an antireflection coating;
Figure 12 is a schematic sectional view of a photodetector having a two-dimensional electron gas; and
Figure 12a is a more detailed view of a layer structure used to provide the two-dimensional electron gas shown in Figure 12.

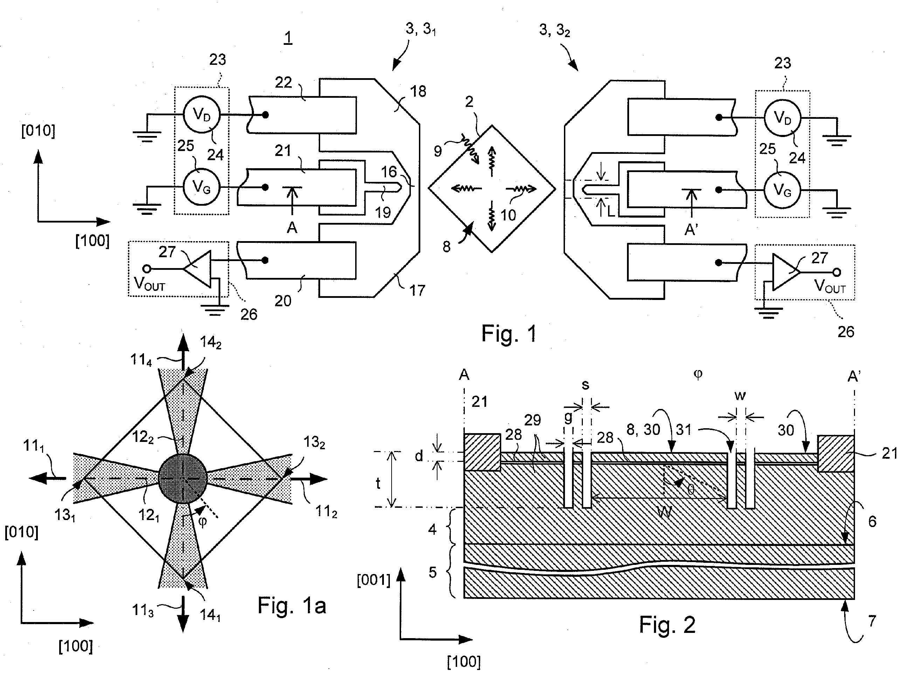

Referring to Figures 1, 1a and 2, a photodetector 1 in accordance with the present invention is shown. The photodetector includes a photoabsorptive region 2 and phonon detectors 3 supported on a common underlying layer structure 4. The photoabsorptive region 2, the phonon detectors 3 and the underlying layer structure 4 are provided on a substrate 5 on an upper (or "top") surface (or "side") 6 of the substrate 5. The substrate 5 also has an opposite, bottom surface or side 7. As will be explained in more detail later, the photoabsorptive region 2 and phonon detectors 3 may be formed by etching a semiconductor layer structure to leave the photoabsorptive region 2 and phonon detectors 3 upstanding from the underlying layer structure 4.

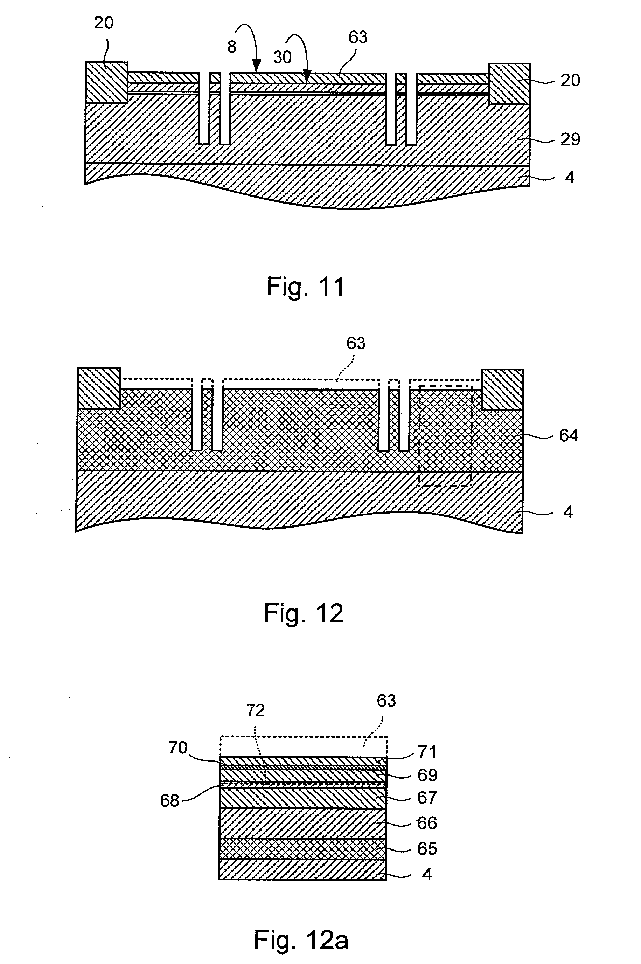

The photoabsorptive region 2 is generally planar and has a face 8 which can receive photons 9. The face 8 may be coated with an antireflection layer or layers 63 (Figure 11). In this example, the photoabsorptive region 2 is generally diamond-shaped in plan view and has an area of about 30 × 30 µm². The photoabsorptive region 2 has sides of equal length and the width, W, across the photoabsorptive region 2 is about 42 µm. The photoabsorptive region 2 can be smaller or large having, for example, an area between about 100 µm² to about 1 mm². Preferably, the area is about an area of about 100 × 100 µm². The photoabsorptive region 2 and phonon detectors 3 are coplanar.

The photoabsorptive region 2 can receive photons 9 through its face 8 and in response thereto generate phonons 10. The photoabsorptive region 2 does not receive photons 9 through the bottom side 7 of the substrate 5. The phonons 10 propagate anisotropically through the photoabsorptive region 2 and underlying layer structure 4 in preferred directions 11₁, 11₂, 11₃, 11₄ Phonons 10 may preferentially propagate at certain azimuthal angles, ϕ, for example ϕ = 0, 90°, 180° and 270°. The phonons 10 may have an angular spread, e.g. a few degrees about a median angle. The phonons 10 may preferentially propagate within a certain range of zenithal angles, θ, for example (90 - Δ)° to 90°, where Δ > 0°.

Phonon propagation in preferred directions can arise as a result of "phonon focussing" and reference is made to "Focussing of Phonon in Crystalline Solids due to Elastic Anisotropy" by B. Taylor et al., Physical Review B, volume 3, page 1462 (1971), "Phonon focusing in cubic crystals" by D. C. Hurley & J. P . Wolfe, Physical Review B, volume 32, page 2568 (1985), "Imaging of Phonon-Drag Effect in GaAs-AlGaAs Heterostructures", H. Karl et al., Physical Review Letters, volume 61, page 2360 (1988) and "Dispersive anisotropic ballistic phonon propagation in [100] GaAs" by H. Kittel et al., Zeitschrift für Physik B Condensed Matter, volume 77, page 70 (1989). Phonon propagation in preferred directions can, additionally or alternatively, arise as a result of other mechanisms. For example, phonon propagation can be guided or focussed, at least partially, using structures, such as a thin layer or layers, an etched channel and/or phononic crystal. These structures may affect the mean free scattering length compared, for example, to bulk material.

As explained earlier, the photoabsorptive region 2 is generally diamond-shaped in plan view and has perpendicular axes 12₁, 12₂ extending between first and second pairs of vertices 13₁, 13₂, 14₁, 14₂. The diamond shape and pointed vertices 13₁, 13₂, 14₁, 15₂ can help to focus phonons on the phonon detectors 3. The axes 12₁, 12₂ of the photoabsorptive region 2 are arranged along the preferred directions 11₁, 11₂, 11₃, 1₁4.

The photoabsorptive region 2, phonon detectors 3 and underlying supporting structure 4 are formed in single crystal gallium arsenide (GaAs) grown on [001] GaAs substrate 5. Therefore, the phonon propagation occurs along [100] and [010] directions.

The phonon detectors 3 take the form of nanowire field-effect transistors 3₁, 3₂ arranged next to the photoabsorptive region 2. In this example, there are two field-effect transistors 3₁, 3₂ arranged on opposite sides of the photoabsorptive region 2. However, as will be explained in more detail later, there may be additional field-effect transistors.

Each nanowire field-effect transistor 3₁, 3₂ includes a narrow, elongate channel 16, first and second enlarged contact regions 17, 18 and a finger-like side gate 19. The channel 16 and contact regions 17, 18 together form a structure which is generally 'C'-shaped in plan view. The side gate 19 lies perpendicular to the channel 16 and is arranged such that its distal end points at the middle of the channel 16. As shown in Figure 1, the channel 16 lies between the photoabsorptive region 2 and the side gate 19. Using a transistor as a phonon detector can have the advantage that the operating point of the detector can be adjusted so as to maximise sensitivity. However, a channel without a gate can be used as a phonon detector.

The nanowire channel 16 has a length, L, of about 4 µm and a width, w, lying in a range between about 100 nm to 2 µm. The channel 16 may be shorter or longer, for example, from about 1 µm to about 10 µm. The side gate 19 is separated from the nanowire channel 16 by a gap, g, of about 50 to about 200 nm. The nanowire channel 16 is separated from the photoabsorptive region 2 by a gap, s, of about 100 nm to about 2 µm. Each nanowire field-effect transistor 3₁, 3₂ includes first, second and third ohmic contacts 20, 21, 22 to provide respective low-resistance connections to the contact regions 17, 18 and side gate 19.

The distance between the centre of the photoabsorptive region 2 and the nanowire channel 16 is less, preferably much less (for instance, about an order of magnitude less), than the phonon mean free path, λ. In bulk GaAs, the mean free path can lie in the range of about 350 µm to about 800 µm and reference is made to "Characterization of single-crystalline GaAs by imaging with ballistic phonons", by E. Held et al., Zeitschrift für Physik B Condensed Matter, volume 75, page 17 (1989). In other bulk materials, the phonon mean free path may be different. Furthermore, as mentioned earlier, structures may also affect the phonon mean free path.

The nanowire field-effect transistors 3₁, 3₂ are controlled using a voltage source unit 23 which include sources 24 for applying a respective bias, V_{D}, to the drain contacts 18 of respective transistors 3₁, 3₂ and voltage sources 25 for applying a respective bias, V_{G}, to the gate contacts 19 of respective transistor 3₁, 3₂. The outputs of the field-effect transistors 3₁, 3₂ are measured using an amplifier unit 26 including a pair of amplifiers 27.

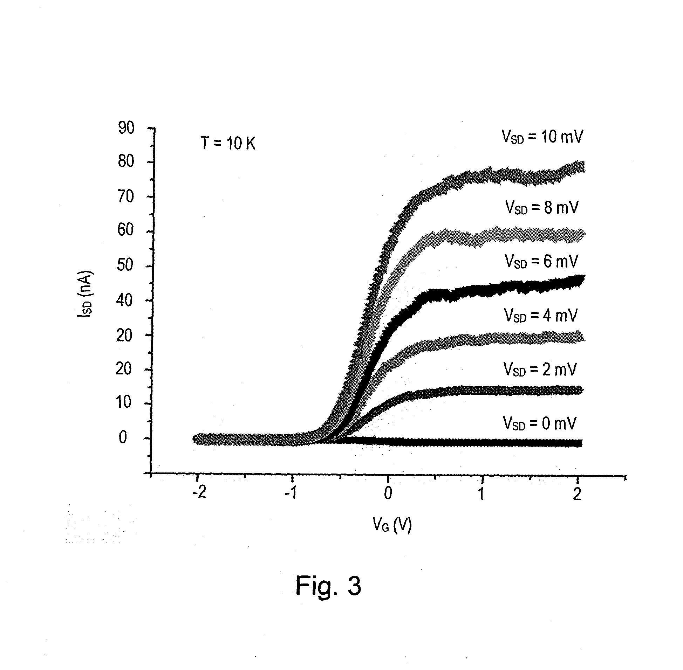

Referring to Figure 3, transfer behaviour for the field-effect transistors 3₁, 3₂ is shown. Figure 3 shows plots of source-drain current, I_{SD}, against gate voltage, V_{G}, for six different values of source-drain voltages, V_{SD}. The measurements are taken at 10 K. As shown in Figure 3, the source-drain current, I_{SD}, can be varied from 0 to 90 nA by changing the gate voltage, V_{G}, from -2V to 2V.

The photodetector can be operated at lower temperatures, for instance to 4.2 K and below. However, the photodetector may be operated at a higher temperature, for example up to about 25 K.

To measure phonons generated as a result of absorption of low numbers of single photons, the field-effect transistors 3₁, 3₂ need not operate as single-electron transistors. This can have advantages, such as allowing the photodetector to operate at higher temperatures and/or increasing its sensitivity.

Referring again to Figure 2, the photoabsorptive region 2 and phonon detectors 3 include portions 28 of a conductive sheet layer embedded in a patterned semiconductor layer structure 29. In this example, the conductive sheet layer portions 28 take the form of regions of a δ-doped layer. The δ-doped layer is embedded in intrinsic GaAs and takes the form of a thin layer (about 2 nm thick) of GaAs doped with silicon with a sheet concentration of about 5×10¹² cm⁻². The δ-doped layer lies at a depth, d, below the surface 30 of the semiconductor layer structure 29. In this example, the depth, d, is about 30 nm. In the nanowire field-effect transistors 3₁, 3₂, the δ-doped layer regions form the elongate channel 16, contact regions 17, 18 and side gate 19. The photoabsorptive region 2 and the phonon detectors 3 are preferably formed from the same material, for example, fabricated from the same (i.e. original or un-patterned) conductive sheet layer. This can help to increase efficiency, for instance, using resonant absorption.

The conductive sheet layer can serve as a region for recombination of photo generated charge carriers (which may be generated in the conductive sheet layer or in layer(s) above or below). This can help to generate phonons in a plane, i.e. in the conductive sheet layer. The conductive sheet layer (or other layer structure) can also help to guide phonons 10 (Figure 1) through the layer and, thus, parallel to the surface of the layer structure.

The photoabsorptive region 2 and phonon detectors 3 are defined and isolated from each other by etched trenches or regions 31 which reveal the underlying layer structure 4. The etched regions 31 have a depth, t, of about 1 µm.

As explained earlier, when the photoabsorptive region 2 absorbs a photon 9, it generates one or more phonons 10. In particular, the photoabsorptive region 2 absorbs a photon 6 and generates an electron-hole pair (not shown) which recombine to generate a photon (not shown) and a longitudinal optical phonon which in turn decays to produce two acoustic phonons, for example a longitudinal acoustic phonon and a transverse acoustic phonon, or two transverse acoustic phonons. The acoustic phonons propagate towards the edge of the photoabsorptive region 2 and then through the channels 16 of the field-effect transistors 3₁, 3₂.

Photons 9 may be absorbed in different ways, for example, without generating electron-hole pairs, to generate phonon(s) 10. Moreover, the type and/or number of phonons 10 generated may also vary, for example, depending on material and the photon energy. For instance, if the photon energy exceeds the band gap energy (or other optical transition energy) by the energy of equivalent to one optical phonon (in GaAs, 36 meV), then only one optical phonon may be generated decaying in two acoustic phonons. However, a higher number of optical and/or acoustic phonons may be generated if the photon energy is higher.

At temperatures of around 10 K, the main scattering mechanism in GaAs is due to acoustic phonons via deformation potential and piezoelectric coupling. Reference is made to "Resonant absorption of terahertz electromagnetic waves by heated electrons in AlGaAs/GaAs Heterostructures" by W. Xu and C. Zhang, Applied Physics Letters, volume 68, page 3305 (1996). Acoustic phonons can be resonantly absorbed by the conductive sheet layer portion 28 forming the channel 16 of a nanowire field-effect transistor 3₁, 3₂.

Absorption of phonons by the channel 16 leads to a change in source-drain current, I_{SD}. The photoconductive gain can be up to 10⁹ AW⁻¹.

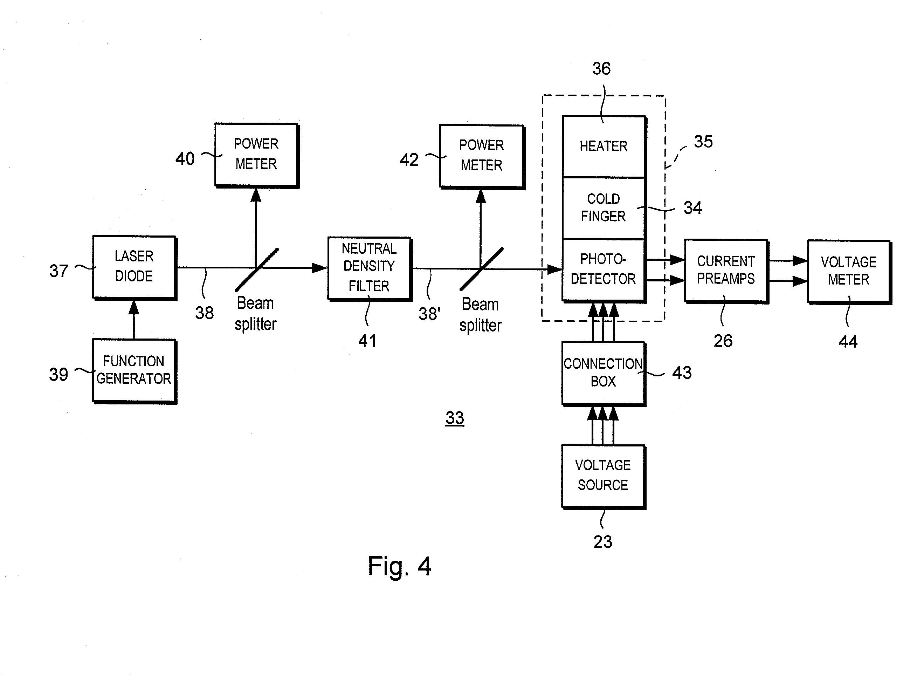

Referring to Figure 4, a system 33 in which the photodetector can operate is shown.

The photodetector is mounted on a cold finger 34 of a cold-finger cryostat 35. Temperature of the cold finger 34 is controlled using a proportional-integral-differential-controlled heater 36.

A semiconductor laser diode 37 is driven by a power supply (not shown) to produce laser light 38 having average power of about 100 nW and a wavelength of about 800 nm. The laser light 38 is pulsed and its pulse pattern is controlled using a programmable function generator 39. The frequency of pulses can lie in the range from about 0.01 Hz to about 100 MHz. A first calibrated power meter 40 can be used to measure the power of the laser light 38. A neutral density filter 41 is used to attenuate the laser light 38 and so reduce beam power by a factor up to 10⁻¹³. A second calibrated power meter 42 can be used to measure the power of the attenuated laser light 38'.

The nanowire field-effect transistors 3₁, 3₂ (Figure 1) of the photodetector are controlled using a voltage source unit 23 connected via a junction box 43.

The nanowire field-effect transistors 3₁, 3₂ (Figure 1) are biased with d.c. voltages via low-pass filters (not shown) so as to minimise noise. The source contacts 17 (Figure 1) are connected to a low-noise current preamplifier unit 26. Filters can be selected according to the function generator 39 used to drive the laser diode 37. The output voltages, V_{OUT}, from the low-noise current preamplifiers 27 (Figure 1) are measured using digital multimeters 44.

The photodetector is mounted to the cold finder 34 so as to be in good thermal contact, for example, using silver dag. Furthermore, the cold finger 34 preferably has a large heat capacity. This can help to dissipate heat and, thus, allow pulse frequency to be increased.

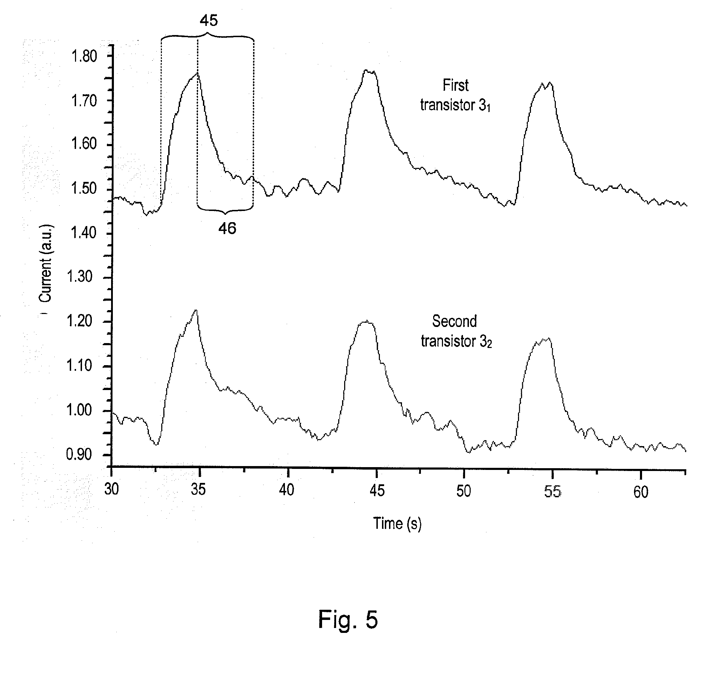

Figure 5 shows responses of the nanowire field-effect transistors 3₁, 3₂ (Figure 1) to light pulses 38' (Figure 4) having a pulse repetition frequency of 0.1 Hz and a 20% duty cycle at 10 K. The responses show pulses 45 having trailing edges 46. The rate of fall off of the trailing edges 46 depends on rate of phonon dissipation.

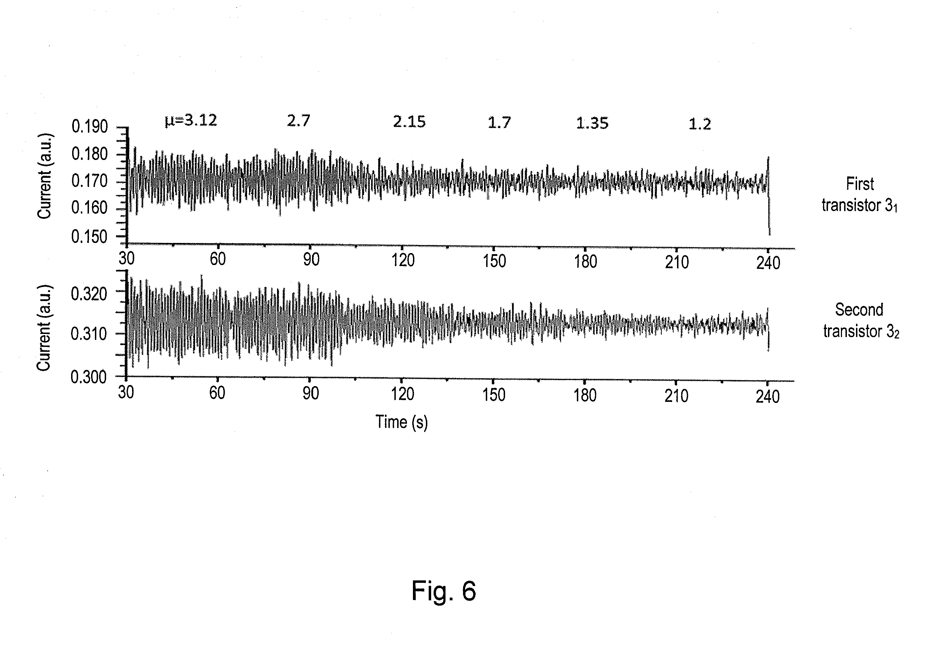

Figure 6 shows responses of the nanowire field-effect transistors 3₁, 3₂ (Figure 1) in real time to light pulses 38' (Figure 4) having different power intensities and a pulse repetition frequency of 1 Hz and a 20% duty cycle at 10 K. The average number of photons, µ, varies from 3.12 to 1.2.

As shown in Figure 6, the measured current depends on the average number of photons and indicates that the photodetector is capable of resolving the number of photons.

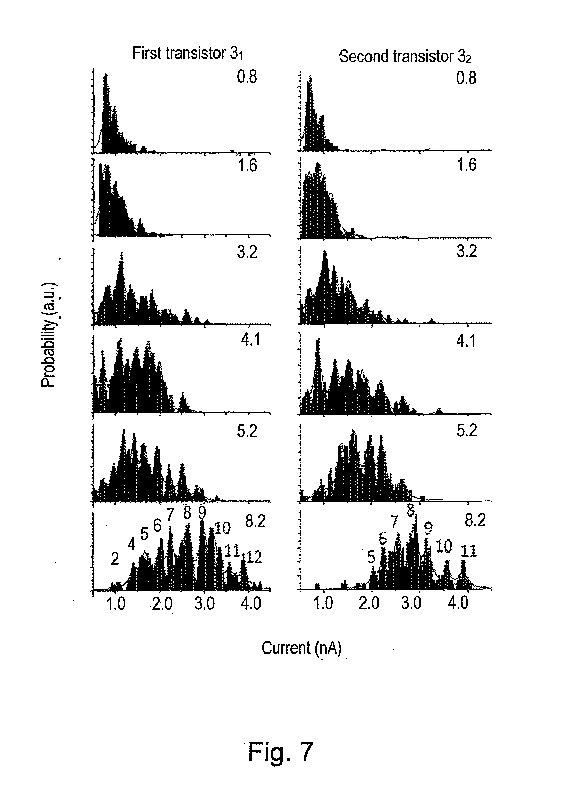

Figure 7 illustrates probability histogram plots for the first and second nanowire field-effect transistors 3₁, 3₂ (Figure 1) for different average photon numbers, i.e. µ, varies from 0.8 to 8.2. About 1800 measurements were taken at 10 K to generate the histograms. Peaks indicate quantized photon number. Gaussian profile can be fitted to the peaks.

The maximum internal quantum efficiency is about 92%.

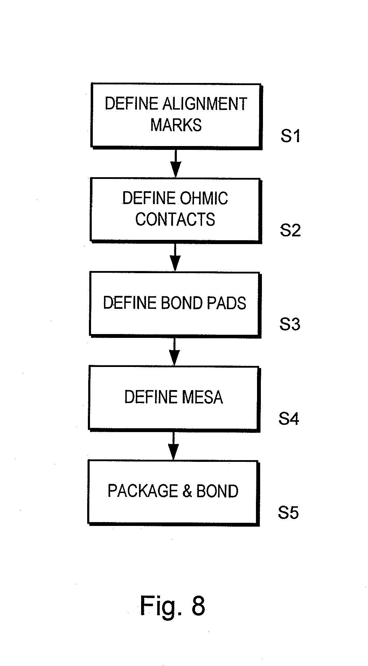

Referring to Figures 1, 8 and 9a to 9e, a method of fabricating a photodetector will now be described.

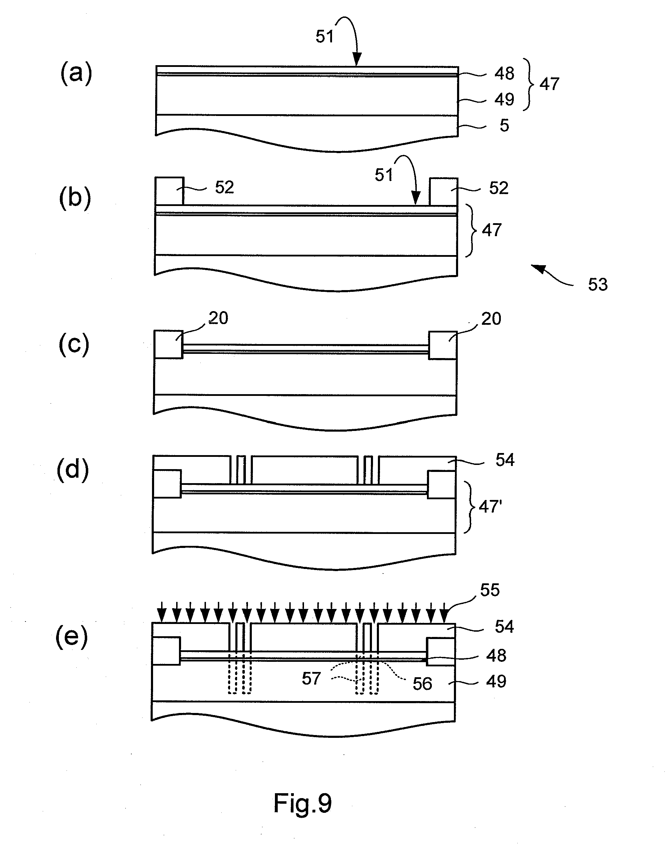

Referring in particular to Figure 9a, a layer structure 47 is provided in which a δ-doped layer 48 is embedded in intrinsic GaAs 49 grown on a [001] gallium arsenide substrate 5. As will be explained in more detail later, other layer structures may be used.

The layer structure 47 has an upper surface 51 which is cleaned and on which alignment marks (not shown) are provided (step S1).

The alignment marks (not shown) are defined in a well-known manner by spin-coating, exposing and developing a bi-layer of low-molecular weight and high-molecular weight electron-beam resists, thermally evaporating a layer of chromium (Cr) followed by a layer of gold (Au) and lifting off unwanted regions of the metal layers, i.e. those which overlie unexposed areas of resist, so as to leave metallic alignment marks.

Ohmic contacts are then provided on the upper surface 51 (step S2).

Referring in particular to Figure 9b, pads 52 of ohmic contact material are defined in a well-known manner by spin-coating, exposing and developing a bi-layer of low-molecular weight and high-molecular weight electron-beam resists, thermally evaporating a mixture of gold (Au), germanium (Ge) and nickel (Ni) followed by a layer of gold (Au) and lifting off unwanted regions of the metal layers so as to leave regions 52 of ohmic contact material.

This leaves a sample 53 in which regions 52 of ohmic contact material lie on the upper surface 51 of the layer structure 47.

Referring in particular to Figure 9c, alloyed ohmic contacts 20 are formed by annealing the sample 53 at about 420 °C to 440 °C.

Bond pads (not shown) are provided on the alloyed ohmic contacts 20 (step S3) using the same process used to define the alignment marks, but using a different pattern. The bond pads (not shown) comprise a layer of chromium (Cr) and an over-layer off gold (Au).

The photoabsorptive region 2 and nanowire field-effect transistors 3₁, 3₂ are defined (step S4).

Referring in particular to Figure 9d, spin-coating, exposing and developing a bi-layer of low-molecular weight and high-molecular weight electron-beam resists leaves an etch mask 54 over the annealed layer structure 47'.

Referring in particular to Figure 9e, reactive ion etching using a mixture of silicon tetrachloride and argon (SiCl₄/Ar) as a feed gas at 20 mTorr and 200 W removes portions 56 of the δ-doped layer 48 and portions 57, 58 of GaAs 49 lying under and over the δ-doped layer 48.

The resist is removed to leave a structure as shown in Figure 2.

Finally, the photodetector is packaged and bond wires (not shown) connected to the bond pads (not shown).

It will be appreciated that other fabrication processes, such as other lithography processes, other deposition processes and/or other etching processes, can be used. For example, optical lithography may be used. Metallisation layers may be deposited by sputtering and can then be etched to leave patterned metallisation regions. Wet etching or other dry etching processes may be used.

It will also be appreciated that the processing materials (such as choice of resist, ohmic contact material) and processing parameters (such as layer thickness, deposition rates, etch rates and annealing parameters) can be found by routine experiment.

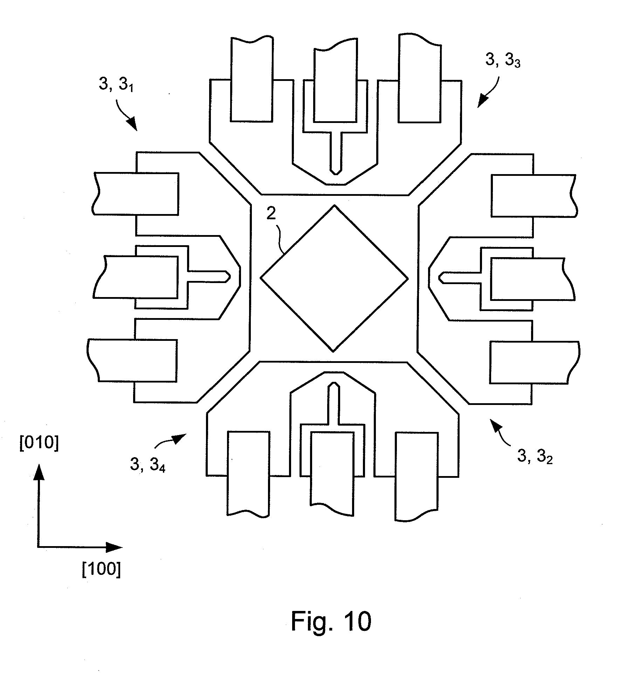

Referring to Figure 10, the photodetector 1 may be modified to include four nanowire field-effect transistors 3₁, 3₂, 3₃, 3₄ arranged around the photoabsorptive region 2. This can increase the sensitivity of the photodetector.

Referring to Figure 11, the photodetector may be modified by including an antireflection coating 63 on the upper surface 30 of the patterned semiconductor layer structure 29. The antireflection coating 63 may include several layers comprising, for example, alternating layers of two types of dielectric material.

As explained earlier, other layer structures can be used. For example, material systems which provide a two-dimensional electron gas or two-dimensional hole gas may be used, such as aluminium gallium arsenide and gallium arsenide heterostructure (AlGaAs/GaAs). However, other III-V materials can be used. Moreover, other non-III-V materials can be used, such as silicon or germanium or silicon-germanium.

Referring to Figure 12 and 12a, a photodetector which is similar to the photodetector described earlier but which has a different layer structure 64 is based on AlGaAs/GaAs heterostructure is shown. As shown in Figure 12, an antireflection coating 63 may be provided.

Referring in particular to Figure 12a, the layer structure 64 is grown on a [001] GaAs substrate 4 and includes buffer layer 65 containing about 30 periods of a GaAs/Al_{0.37}Ga_{0.63}As superlattice, a layer 66 of intrinsic GaAs having a thickness of about 1 µm, a layer 67 of undoped Al_{0.37}Ga_{0.63}As having a thickness of about 50 nm, a layer 68 of undoped GaAs having a thickness of about 10 to 50 nm, a spacer layer in the form of a layer 69 of undoped Al_{0.37}Ga_{0.63}As having a thickness of about 30 to 200 nm, a layer 70 of GaAs doped with silicon to a sheet concentration of about 5×10¹² cm⁻² followed by a layer 71 of intrinsic GaAs having a thickness of about 15 to 20 nm. A two-dimensional electron gas 72 is formed in the intrinsic GaAs layer 68 below the interface with the spacer layer 66.

It will be appreciated that many modifications may be made to the embodiments hereinbefore described.

As explained earlier, the photoabsorptive region can have a different shape (in plan view), such as a regular polygon (such as a hexagon) or irregular polygon. The photoabsorptive region can also have a different size (e.g. area) or volume.

The transistors may be differently configured. For example, the transistors may have a top or bottom gate. The channel and contacts may have a different geometry.

The phonon detectors need not be provided on opposite sides of the photoabsorptive region. For example, a phonon detector may be arranged at one end of the photoabsorptive region and another can be placed on one side.

The conductive sheet layer may be differently configured. For example, the δ-doped layer may comprise a different dopant (n- or p-type) and may have a different areal doping concentration. The thickness of the capping layer may differ. If an AlGaAs/GaAs heterostructure is used, then doped layer may have different doping concentrations and the layer thicknesses may also differ.

Direct or indirect band gap materials may be used.

There may be more than one conductive sheet layer. For example, additional conductive sheets may be used in the photoabsorptive region to improve recombination.

A substrate may support more than one photodetector. For example, several photodetectors may be arranged in an array. The photodetectors may be spaced apart, e.g. by many times the phonon scattering length, so as to minimise cross talk. Additionally or alternatively, the number of photodetectors used at any one time may be limited, e.g. to just one.

A substrate may support one (or more) photodetectors and processing circuitry, such amplifiers and/or logic gates. Thus, processing circuitry can be used to process signals from the photodetector(s).

The system used to provide light pulses may be different. For example, other sources of light may be used. The wavelength of light used, the pulse duration and the pulse repetition frequency may differ from those values given earlier. Moreover, pulses need not periodic, but may be sporadic.

The photoabsorptive region and phonon detectors need not be made from the same materials. The photoabsorptive region may be formed from one or more regions, for example layers, of semiconductor materials. The photoabsorptive region may be formed from or may include a region, for example a layer, of a metal, such as aluminium or metal alloy. The metallic layer(s) may be provided in addition to a conductive sheet layer, such as two-dimensional electron gas.

## Claims

1. A photodetector comprising:
a substrate having a first side and a second, opposite side;
a photoabsorptive region to absorb photons and produce phonons in response thereto, wherein phonons propagate anisotropically having at least one preferred direction of propagation; and
at least one conductive channel configured to receive phonons propagating along a preferred direction of propagation;
wherein the photoabsorptive region and the at least one conductive channel are provided on the first side of the substrate.

2. A photodetector according to claim 1, wherein the photoabsorptive region is planar and the or each conductive channel lies in a plane which is substantially coplanar with the photoabsorptive region.

3. A photodetector according to claim 1 or 2, wherein the photoabsorptive region includes a conductive sheet and the or each conductive channel includes a respective conductive sheet.

4. A photodetector according to claim 3, wherein the conductive sheets each comprise a respective portion of a δ-doped layer in a semiconductor layer structure.

5. A photodetector according to claim 3, wherein the conductive sheets comprise a respective portion of a two-dimensional electron or hole gas.

6. A photodetector according to any preceding claim, wherein the or each conductive channel is configured to lie within about 5 µm, preferably within about 2 µm, of the photoabsorptive region.

7. A photodetector according to any preceding claim, wherein the photoabsorptive region is polygonal having vertices and each conductive channel is configured to run adjacent to a respective vertex.

8. A photodetector according to any preceding claim, wherein the photoabsorptive region is rhomboidal having four vertices and each conductive channel is configured to run adjacent to a vertex.

9. A photodetector according to any preceding claim, wherein the photoabsorptive region is planar and has a face having an area between about 100 µm² and about 10000 µm².

10. A photodetector according to any preceding claim, wherein each conductive channel is provided with a respective gate so as to form at least one field-effect transistor.

11. A photodetector according to any preceding claim, wherein the photoabsorptive region is configured to absorb a photon and generate an electron-hole pair in response thereto and at least one phonon is generated in response to the electron and hole recombining.

12. Apparatus for receiving photons and resolving received photon number, the apparatus comprising:
a photodetector according to any preceding claim; and
a refrigerator in thermal contact with the photodetector configured to cool the photodetector to a temperature of between about 1 K and about 50 K.

13. A method of fabricating a photodetector, the method comprising:
providing a substrate having a first side and a second, opposite side;
providing, on the first side, a photoabsorptive region to absorb photons and produce phonons in response thereto, wherein phonons propagate anisotropically having at least one preferred direction of propagation; and
providing, on the first side, at least one conductive channel configured to receive phonons propagating along a preferred direction of propagation.

14. A method according to claim 13, wherein providing the photoabsorptive region and providing at least one conductive channel comprises:
providing a layer structure including a conductive sheet on the substrate; and
etching regions of the layer structure so as to leave a photoabsorptive region including a region of the conductive sheet and at least one conductive channel including respective regions of the conductive sheet.

15. A method of operating a photodetector which comprises a substrate having a first side and a second, opposite side, a photoabsorptive region to absorb photons and produce phonons in response thereto, wherein phonons propagate anisotropically having at least one preferred direction of propagation and at least one conductive channel configured to receive phonons propagating along a preferred direction of propagation, wherein the photoabsorptive region and the at least conductive channel are provided on the first side of a substrate, the method comprising:
cooling the photodetector to a temperature about 1 K and 50 K;
applying a bias across the conductive channel; and
measuring current through the conductive channel.
